# DEMANDE DE BREVET EUROPEEN

(11) **EP 2 447 886 A1**
(43) Date de publication de la demande: **02.05.2012**
(21) Numéro de dépôt: 10306092.7
(22) Date de dépôt: 07.10.2010
(51) Int. Cl.: G06K 19/077

(54) **Module électronique sécurisé, dispositif à module électronique sécurisé et procédé de fabrication**

(71) Demandeur: Gemalto SA, 92190 Meudon (FR)
(72) Inventeur: DOSSETTO, Lucile, 92197, MEUDON CEDEX (FR); AUDOUARD, Laurent, 92197, MEUDON CEDEX (FR); LAVIRON, Thierry, 92197, MEUDON CEDEX (FR); OTTOBON, Stéphane, 92197, MEUDON CEDEX (FR)

(57) **Abrégé**

L'invention concerne un module électronique sécurisé (1) comportant au moins une zone de contact électrique (5) sur une face, et ayant sur la face opposée au moins une puce électronique (9) reliée à ladite au moins une zone de contact électrique (5) par des connectiques (11), ledit module électronique (1) comportant en outre, sur la même face que ladite puce électronique (9), au moins un moyen périphérique de protection (7) définissant un périmètre de protection autour de ladite puce électronique (9) et de ses connectiques (11), la hauteur dudit au moins un moyen périphérique de protection (7) étant supérieure à la hauteur de la puce électronique (9) et de ses connectiques (11).

## Description

La présente invention se rapporte au domaine technique des modules électroniques, aux procédés de fabrication d'un module électronique, ainsi qu'aux dispositifs électroniques, en particulier aux cartes à puces, comportant au moins un module électronique. Plus précisément, l'invention ce rapporte aux modules électroniques sécurisés.

De façon générale, les modules électroniques sont formés par un film support diélectrique sur lequel est laminée une couche métallisée. Sur la face opposée à la couche métallisée est collée une puce électronique connectée à différentes zones de contact électrique de la couche métallisée.

Dans un dispositif électronique, le module électronique est collé dans une cavité prévue à cet effet dans le corps du dispositif.

Ce genre de module électronique trouve application notamment dans les cartes à puces.

Cependant, les normes concernant le paiement électronique notamment par cartes bancaires ou concernant les pièces d'identité électroniques, demandent une plus grande inviolabilité mécanique en particulier le fait que l'on ne puisse retirer le module électronique pour le réutiliser par la suite.

Une solution consiste à réaliser un collage structural ou par ancrage mécanique de la puce dans une résine solidaire du fond de la cavité du corps du dispositif. Ainsi, lors d'une tentative de démontage du module électronique, la puce est solidaire de la résine et reste dans la cavité du corps du dispositif électronique et est donc déconnectée de la couche métallisée. Le démontage du module électronique pour une réutilisation ultérieure est donc rendu impossible.

Cependant, la manipulation de modules électronique avec la puce et ses connectiques à nue, afin de fabriquer de tels dispositifs électroniques sécurisés, est problématique car rien ne protège la puce électronique et les connectiques à nue, avant la mise en place sur le corps du dispositif électronique. Ainsi la puce électronique peut être endommagée et les connectiques peuvent se détacher de la couche métallisée ou même se briser lors des manipulations, rendant de fait le module électronique inutilisable.

Les risques de détérioration du module électronique alors que la puce électronique et ses connectiques sont à nue et avant la mise en place sur le corps du dispositif électronique, sont d'autant plus importants que la fabrication desdits modules électroniques peut être effectuer longtemps auparavant, voir même dans un lieu différent de la fabrication du dispositif électronique en lui-même. Il peut donc y avoir manipulation, conditionnement, stockage et transport du module électronique avant que celui-ci ne soit utilisé. Ce qui augmente considérablement les risques de détérioration et de pertes de modules électroniques lors de ces processus et donc peut avoir un coût important.

Un des buts de l'invention est donc de présenter un module électronique sécurisé, pouvant être manipulé avec la puce et ses connectiques à nue, et ce en évitant le plus possible la détérioration dudit module électronique.

Ainsi, la présente invention concerne un module électronique sécurisé comportant au moins une zone de contact électrique sur une face, et ayant sur la face opposée une puce électronique reliée à ladite au moins une zone de contact électrique par des connectiques, ledit module électronique comportant en outre, sur la même face que ladite puce électronique, au moins un moyen périphérique de protection définissant un périmètre de protection autour de ladite puce électronique et de ses connectiques, la hauteur dudit au moins un moyen périphérique de protection étant supérieure à la hauteur de la puce électronique et de ses connectiques.

On entend par le fait que la hauteur dudit au moins un moyen périphérique de protection est supérieure à celle de la puce électronique et de ses connectiques, que le plan formé par le ou les sommets du ou des moyens périphériques de protection ne coupe ni la puce électronique ni les connectiques. Ainsi du fait de la protection apportée par le ou les moyens périphériques de protection, il est possible de manipuler le module électronique avec un risque de détérioration beaucoup plus faible, et ce alors que la puce et ses connectiques sont à nue.

Selon un aspect de l'invention, ledit au moins un moyen périphérique de protection forme un cadre autour de la puce électronique et des ses connectiques.

Selon un autre aspect de l'invention, ledit module électronique comporte sur la face opposée à la zone de contact électrique, un film de support diélectrique sur lequel est fixé ledit au moins un moyen périphérique de protection, la puce électronique est fixée sur ledit film support et est reliée à la zone de contact électrique par des connectiques passant par des orifices.

Selon un autre aspect de l'invention, ledit au moins un moyen périphérique de protection est un cordon de matière déposé sur le film support et entourant la puce électronique et ses connectiques.

Selon un autre aspect de l'invention, ledit au moins un moyen périphérique de protection forme une couche sur toute la surface du module électronique, évidée au niveau de la puce électronique et de ses connectiques.

L'invention concerne également un procédé de fabrication d'un module électronique sécurisé comportant au moins une zone de contact électrique sur une face, et ayant sur la face opposée une puce électronique reliée à ladite au moins une zone de contact électrique par des connectiques, ledit procédé de fabrication comportant une étape de mise en place d'au moins un moyen périphérique de protection définissant un périmètre de protection autour de ladite puce électronique, sur la même face que ladite puce électronique, la hauteur dudit au moins un moyen périphérique de protections étant supérieure à la hauteur de la puce électronique et de ses connectiques.

Selon un aspect de l'invention, la mise en place du au moins un moyen périphérique de protection est effectué sur un film support diélectrique.

L'invention concerne également un dispositif électronique comprenant au moins un module électronique sécurisé comportant au moins une zone de contact électrique sur une face, et ayant sur la face opposée une puce électronique reliée à ladite au moins une zone de contact électrique par des connectiques, ledit module électronique comportant en outre, sur la même face que ladite puce électronique, au moins un moyen périphérique de protection définissant un périmètre de protection autour de ladite puce électronique et de ses connectiques, la hauteur dudit au moins un moyen périphérique de protections étant supérieure à la hauteur de la puce électronique et de ses connectiques.

Selon un aspect de l'invention, au moins un élément de fixation du module électronique dans le dispositif électronique englobe au moins en partie les connectiques reliant la puce électronique et la zone de contact électrique.

Selon un aspect de l'invention, ledit dispositif électronique est une carte à puce.

L'invention concerne également un procédé de fabrication d'un dispositif électronique comprenant au moins un module électronique sécurisé comportant au moins une zone de contact électrique sur une face, et ayant sur la face opposée une puce électronique reliée à ladite au moins une zone de contact électrique par des connectiques, ledit procédé de fabrication comportant une étape de fixation d'au moins un module électronique comportant en outre, sur la même face que ladite puce électronique, au moins un moyen périphérique de protection définissant un périmètre de protection autour de ladite puce électronique et de ses connectiques, la hauteur dudit au moins un moyen périphérique de protection étant supérieure à la hauteur de la puce électronique et de ses connectiques.

Selon un aspect de l'invention, lors de l'étape de fixation du module électronique sur le dispositif électronique, au moins un élément de fixation englobe au moins en partie les connectiques reliant la puce électronique et la zone de contact électrique.

D'autres caractéristiques et avantages de l'invention apparaîtront plus clairement à la lecture de la description suivante, donnée à titre d'exemple illustratif et non limitatif, et des dessins annexés parmi lesquels :
- La figure 1 représente un schéma simplifié d'un exemple de module électronique, en vue de coupe longitudinale,
- la figure 2 représente un schéma simplifié d'un second exemple de module électronique selon une variante, en vue de coupe longitudinale,
- la figure 3 représente un schéma simplifié d'un troisième exemple de module électronique selon une autre variante, en vue de coupe longitudinale,
- la figure 4 représente un schéma simplifié d'un quatrième exemple de module électronique selon une autre variante, en vue de coupe longitudinale,
- la figure 5 représente un schéma simplifié d'un exemple d'ensemble module électronique et dispositif électronique avant montage, en vue de coupe longitudinale,
- la figure 6 représente un schéma simplifié d'un dispositif électronique, en vue de coupe longitudinale.
- la figure 7 représente un schéma simplifié d'un dispositif électronique selon une variante, en vue de coupe longitudinale.

Les éléments identiques sur toutes les figures sont indiqués par les mêmes numéros de références.

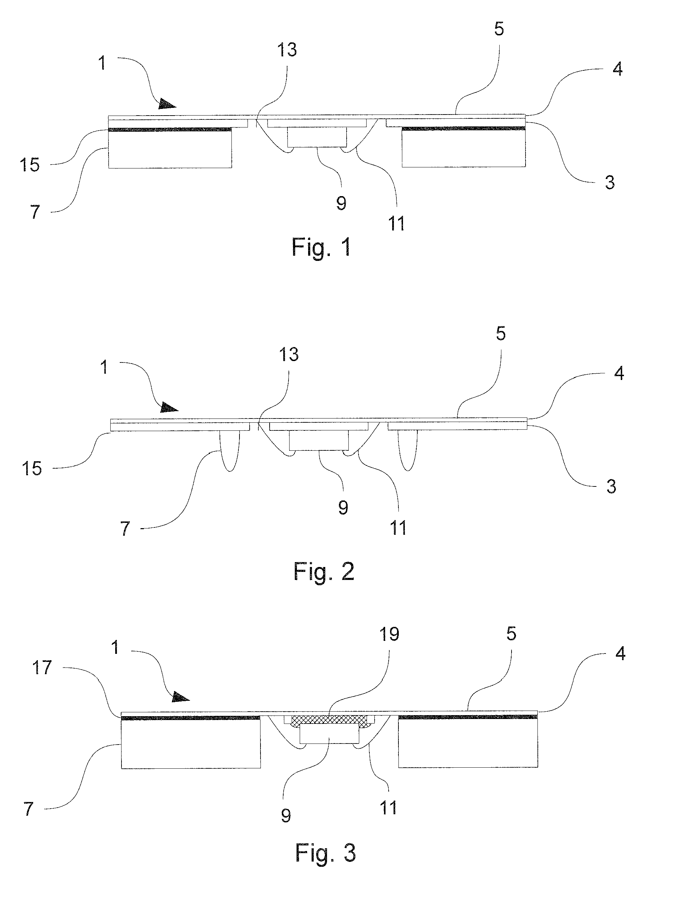

La figure 1 montre un schéma simplifié d'un module électronique 1, en vue de coupe longitudinale.

Le module électronique 1 comporte, selon le mode de réalisation présenté par cette figure, une zone de contact électrique 5 sur une face et un film support 3 sur la face opposée. Sur le film support diélectrique 3 est fixé une puce électronique 9 reliée à la zone de contact électrique 5 par des connectiques 11 passants par des orifices 13 dans ledit film support 3. Ladite puce électronique 9 et ses connectiques 11 sont à nue.

Sur le film support diélectrique 3, est mis en place au moins un moyen périphérique de protection 7 afin de protéger ladite puce électronique 9 et ses connectiques 11. Ce ou ces moyens périphériques de protection 7 définissent un périmètre autour de la puce électronique 9 et des ses connectiques 11. Le ou lesdits moyens périphériques de protection 7 ont une hauteur supérieure à celle de la puce électronique 9 et de ses connectiques, c'est-à-dire que le plan formé par le ou les sommets du ou des moyens périphériques de protection 7 ne coupe ni la puce électronique 9 ni les connectiques 11.

Le ou lesdits moyens périphériques de protection 7 protègent ainsi la puce électronique 9 et ses connectiques 11 lors de manipulations du module électronique 1.

Le ou les moyens périphériques de protection 7 peuvent former un cadre autour de la puce électronique 9 et de ses connectiques 11 et peuvent être en matériaux diélectrique.

Le ou lesdits moyens périphériques de protection 7 peuvent également former une couche recouvrant la surface du module électronique 1 et évidé au niveau de la puce électronique 9 et de ses connectiques 11 comme cela est représenté sur la figure 1.

La mise en place du ou des moyens périphériques de protection 7 peut être assuré par une colle ou un adhésif 15 lorsque le ou les moyens périphériques de protection 7 sont en matière plastique ou plus précisément en PCV (Polychlorure de vinyle).

Selon un mode de réalisation présentée par la figure 2, à l'instar du mode de réalisation présenté par la figure 1, le module électronique 1 comporte une zone de contact électrique 5 sur une face et un film support diélectrique 3 sur la face opposée. Sur le film support 3 est fixée une puce électronique 9 reliée à la zone de contact électrique 5 par des connectiques 11 passants par des orifices 13 dans ledit film support 3. Ladite puce électronique 9 et ses connectiques 11 sont à nue.

Sur le film support diélectrique 3 est mis en place un moyen périphérique de protection 7 composé d'un cordon de matière disposé autour de la puce électronique 9 et de ses connectiques 11. Ce cordon de matière peut, par exemple, être une résine ayant une viscosité élevée.

La figure 3 montre un autre mode de réalisation de l'invention. Dans ce mode de réalisation le ou les moyens périphériques de protection 7 sont directement fixés sur une couche conductrice 4 comportant la zone de contact électrique 5. Le ou lesdits moyens périphériques de protection 7 sont fixés sur la face opposée à ladite zone de contact électrique 5. Dans ce mode de réalisation, la puce électronique est elle aussi fixée sur la couche conductrice 4, au moyen d'une résine non-conductrice 19 par exemple.

Il n'y a donc pas de film support diélectrique 3 dans ce mode de réalisation, cela permet une optimisation des coûts de production.

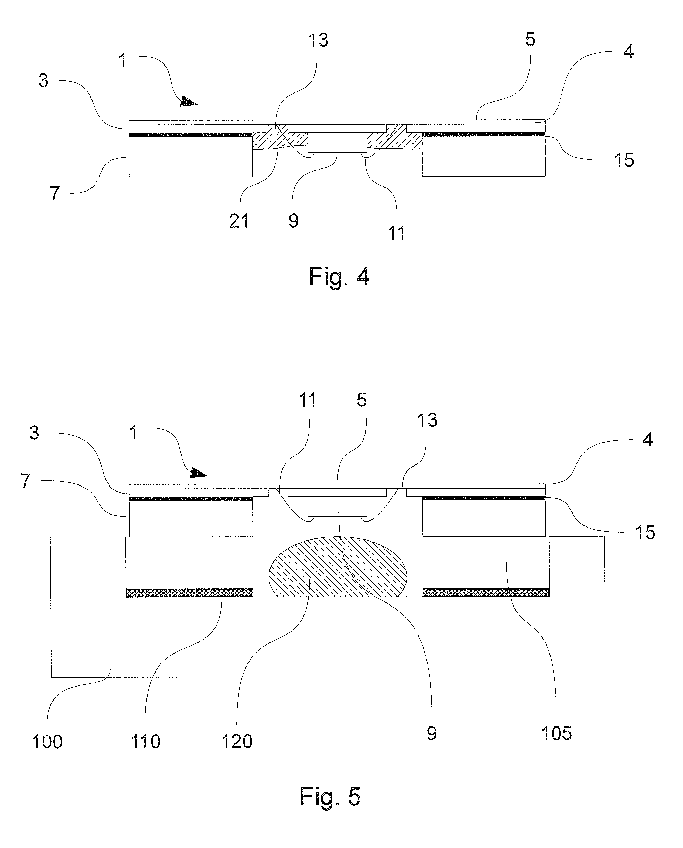

Selon une variante présenté par la figure 4, la puce électronique 9 ainsi que ses connectiques 11 peuvent être partiellement encapsulés dans une résine de protection 21. Par partiellement, on entend qu'au moins une partie de la puce électronique 9 et/ou de ses connectiques 11 restent à nue.

Le procédé de fabrication d'un module électronique 1 selon l'invention, bien connu de l'homme du métier, comprend une étape de mise en place du ou desdits moyens périphériques de protection 7. Cette mise en place du ou des moyens périphériques de protection 7 peut être effectuée sur un film support diélectrique 3 ou bien directement sur la couche conductrice 4, sur la face opposée à la zone de contact électrique 5.

La mise en place du ou desdits moyens périphériques de protection 7 peut être effectuée par fixation au moyen d'une colle ou d'un adhésif 15 sur le film support diélectrique 3, ou bien par la mise en place d'un cordon de matière, comme une résine ayant une viscosité élevée, sur ledit film support diélectrique 3.

Le procédé de fabrication d'un module électronique 1 selon l'invention, peut également comprendre une étape d'encapsulation partielle de la puce électronique 9 et de ses connectiques 11 dans une résine de protection 19.

Les figures 4 et 5 montrent, en vue de coupe longitudinale, un module électronique 1 venant s'insérer dans une cavité 105, prévue à cet effet, d'un corps de dispositif électronique 100, par exemple une carte à puce.

Les moyens périphériques de protection 7 peuvent être fixés au corps du dispositif électronique 100 par un adhésif 110, par exemple un adhésif thermofusible ou thermoactivable.

Une variante de cette fixation est que, dans le cas ou le corps du dispositif électronique 100 est de la même matière que le ou les moyens périphériques de protection 7, une soudure par ultrason est effectuée. Par exemple, le corps du dispositif électronique 100 ainsi que les moyens périphériques de protection 7 peuvent être en PVC (polychlorure de vinyle), assurant ainsi une meilleure compatibilité chimique nécessaire pour une fixation par soudure par ultrason.

L'utilisation d'un module électronique 1 présentant au moins un moyen périphérique de protection 7 selon l'invention, est particulièrement avantageux du fait que dans le cas où ledit moyen périphérique de protection 7 est une couche recouvrant la surface du module électronique 1 et évidé au niveau de la puce électronique 9 et de ses connectiques 11, la cavité 105 du corps du dispositif électronique 100 peut présenter un fond plat. Cette forme simple de la cavité 105 du corps du dispositif 100 permet ainsi une meilleure maitrise des coûts du procédé de fabrication du dispositif électronique 100.

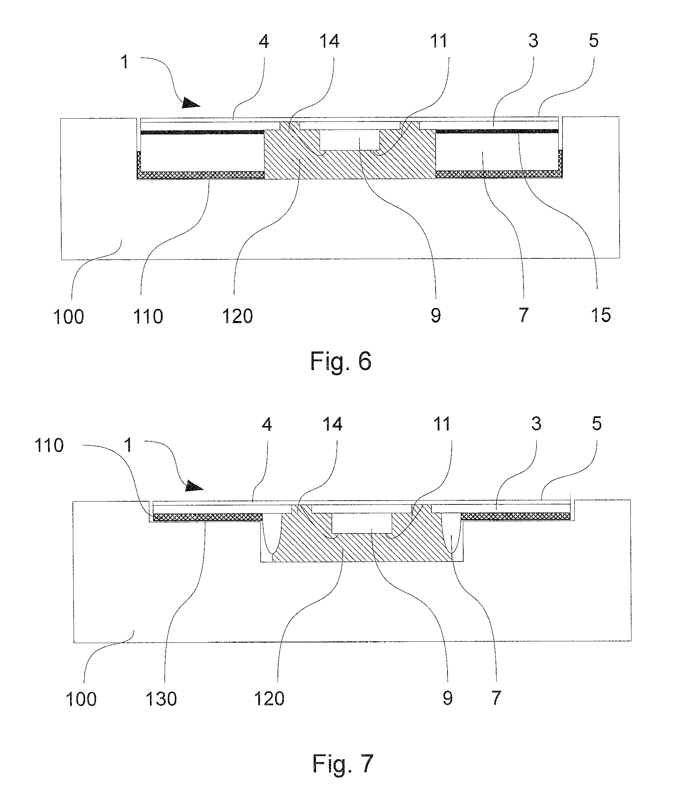

Selon une variante présentée par la figure 7, la fixation du module électronique 1 dans la cavité 105 est obtenue par fixation du film support diélectrique 3 avec un adhésif 110 sur une zone périphérique peu profonde 130 de ladite cavité 105.

Le module électronique 1 est également fixé au corps du dispositif électronique 100 par un élément de fixation 120 qui englobe au moins en partie les connectiques 11 qui relient la puce électronique 9 à la zone de contact électrique 5. Ainsi lors d'une tentative frauduleuse de démontage du module électronique 1 du dispositif électronique 100, les connectiques 11 sont prisonnières de l'élément de fixation 120 dans la cavité 105 et se détachent du module électronique 1, rendant ce dernier inutilisable par la suite. L'élément de fixation 120 peut également englober totalement la puce électronique 9 et ses connectiques 11, et ainsi c'est l'ensemble composé par ladite puce électronique 9 et ses connectiques 11 qui est détaché du module électronique 1 lors d'une tentative frauduleuse de démontage de ce dernier.

Ainsi, grâce à l'action protectrice de moyens périphériques de protection, il est possible d'obtenir un module électronique sécurisé avec au moins une puce électronique et ses connectiques à nue, qui est manipulable avec un faible risque de détérioration, pour la fabrication d'un dispositif électronique sécurise.

## Revendications

1. Module électronique sécurisé (1) comportant au moins une zone de contact électrique (5) sur une face, et ayant sur la face opposée au moins une puce électronique (9) reliée à ladite au moins une zone de contact électrique (5) par des connectiques (11), **caractérisé en ce que** ledit module électronique (1) comporte en outre, sur la même face que ladite puce électronique (9), au moins un moyen périphérique de protection (7) définissant un périmètre de protection autour de ladite puce électronique (9) et de ses connectiques (11), la hauteur dudit au moins un moyen périphérique de protection (7) étant supérieure à la hauteur de la puce électronique (9) et de ses connectiques (11).

2. Module électronique (1) selon la revendication 1, **caractérisé en ce que** ledit au moins un moyen périphérique de protection (7) forme un cadre autour de la puce électronique (9) et des ses connectiques (11).

3. Module électronique (1) selon la revendication 1, **caractérisé en ce que** ledit module électronique (1) comporte sur la face opposée à la zone de contact électrique (5), un film de support diélectrique (3) sur lequel est fixé ledit au moins un moyen périphérique de protection (7), la puce électronique (9) est fixée sur ledit film support (3) et est reliée à la zone de contact électrique (5) par des connectiques (11) passant par des orifices (13).

4. Module électronique (1) selon la revendication 3, **caractérisé en ce que** ledit au moins un moyen périphérique de protection (7) est un cordon de matière déposé sur le film support (3) et entourant la puce électronique (9) et ses connectiques (11).

5. Module électronique (1) selon la revendication 2, **caractérisé en ce que** ledit au moins un moyen périphérique de protection (7) forme une couche sur toute la surface du module électronique (1), évidée au niveau de la puce électronique (9) et de ses connectiques (11).

6. Procédé de fabrication d'un module électronique sécurisé (1) comportant au moins une zone de contact électrique (5) sur une face, et ayant sur la face opposée au moins une puce électronique (9) reliée à ladite au moins une zone de contact électrique (5) par des connectiques (11), **caractérisé en ce que** ledit procédé de fabrication comporte une étape de mise en place d'au moins un moyen périphérique de protection (7) définissant un périmètre de protection autour de ladite puce électronique (9) et de ses connectiques (11), la hauteur dudit au moins un moyen périphérique de protection (7) étant supérieure à la hauteur de la puce électronique (9) et de ses connectiques (11).

7. Procédé de fabrication d'un module électronique sécurisé (1) selon la revendication 6, **caractérisé en ce que** la mise en place du au moins un moyen périphérique de protection (7) est effectué sur un film support diélectrique (3).

8. Dispositif électronique (100) comprenant au moins un module électronique sécurisé (1) comportant au moins une zone de contact électrique (5) sur une face, et ayant sur la face opposée une puce électronique (9) reliée à ladite au moins une zone de contact électrique (5) par des connectiques (11), **caractérisé en ce que** ledit module électronique (1) comporte en outre, sur la même face que ladite puce électronique (9), au moins un moyen périphérique de protection (7) définissant un périmètre de protection autour de ladite puce électronique (9) et de ses connectiques (11), la hauteur dudit au moins un moyen périphérique de protection (7) étant supérieure à la hauteur de la puce électronique (9) et de ses connectiques (11).

9. Dispositif électronique (100) selon la revendication 8, **caractérisé en ce que** au moins un élément de fixation (120) du module électronique (1) dans le dispositif électronique (100) englobe au moins en partie les connectiques (11) reliant la puce électronique (9) et la zone de contact électrique (5).

10. Dispositif électronique (100) selon la revendication 8, **caractérisé en ce que** ledit dispositif électronique (100) est une carte à puce.

11. Procédé de fabrication d'un dispositif électronique (100) comprenant au moins un module électronique sécurisé (1) comportant au moins une zone de contact électrique (5) sur une face, et ayant sur la face opposée une puce électronique (9) reliée à ladite au moins une zone de contact électrique (5) par des connectiques (11), **caractérisé en ce que** ledit procédé de fabrication comporte une étape de fixation d'au moins un module électronique (1) comportant en outre, sur la même face que ladite puce électronique (9), au moins un moyen périphérique de protection (7) définissant un périmètre de protection autour de ladite puce électronique (9) et de ses connectiques (11), la hauteur dudit au moins un moyen périphérique de protection (7) étant supérieure à la hauteur de la puce électronique (9) et de ses connectiques (11).

12. Procédé de fabrication d'un dispositif électronique (100) selon la revendication 11, **caractérisé en ce que** lors de l'étape de fixation du module électronique (1) sur le dispositif électronique (100), au moins un élément de fixation (120) englobe au moins en partie les connectiques (11) reliant la puce électronique (9) et la zone de contact électrique (5).
